(19) Europäisches Patentamt
European Patent Office
Office européen des brevets

(11) EP 0 426 441 B1

(12) **EUROPEAN PATENT SPECIFICATION**

(45) Date of publication and mention
of the grant of the patent:
**11.12.1996 Bulletin 1996/50**

(51) Int Cl.[6]: **G02B 3/00**, G02B 1/04,
B29D 11/00

(21) Application number: **90311907.1**

(22) Date of filing: **30.10.1990**

(54) **An optical device having a microlens and a process for making microlenses**

Optische Vorrichtung mit Mikrolinse und Verfahren zur Herstellung von Mikrolinsen

Dispositif optique comprenant une microlentille et méthode de fabrication de microlentilles

(84) Designated Contracting States:
**DE FR GB NL**

(30) Priority: **30.10.1989 JP 283864/89**
**30.10.1989 JP 283865/89**
**28.05.1990 JP 138084/90**
**30.05.1990 JP 142659/90**

(43) Date of publication of application:
**08.05.1991 Bulletin 1991/19**

(73) Proprietor: **SHARP KABUSHIKI KAISHA**
**Osaka 545 (JP)**

(72) Inventors:
• **Watanabe, Noriko**
**Nara-shi, Nara-ken (JP)**
• **Hamada, Hiroshi**
**Nara-shi, Nara-ken (JP)**
• **Funada, Fumiaki**
**Yamatokoriyama-shi, Nara-ken (JP)**

(74) Representative: **Brown, Kenneth Richard et al**
**R.G.C. Jenkins & Co.**
**26 Caxton Street**
**London SW1H 0RJ (GB)**

(56) References cited:
**EP-A- 0 304 709**      **JP-A- 1 257 901**
**JP-A-61 058 838**

• **PATENT ABSTRACTS OF JAPAN, vol. 10, no. 9 (P-420)(2066) 14 January 1986 ; & JP-A-60 165 623**
• **PATENT ABSTRACTS OF JAPAN, vol. 10, no. 9 (P-420)(2066) 14 January 1986 ; & JP-A-60 165 621**
• **PATENT ABSTRACTS OF JAPAN, vol. 4, no. 118 (P-24)(600) 22 August 1980 ; & JP-A-55 073 012**
• **PATENT ABSTRACTS OF JAPAN, vol. 11, no. 56 (P-549) 20 February 1987 ; & JP-A-61 220 149**

## Description

## BACKGROUND OF THE INVENTION

1. Field of the invention:

The present invention relates generally to the attachment of microlenses to an optical device, and to the production of microlenses to be attached to an optical device. More particularly, the present invention relates to an optical device having a microlens secured thereto, and to a process for producing microlenses for such use on a mass-production basis by use of a light-permissive die or stamper, hereinafter referred to as the "stamper".

2. Description of the prior art:

In this specification, the "microlens" means a lens of a size of not larger than a few millimetres, and also means a group of such microlenses which are arranged one-dimensionally or two-dimensionally. Hereinafter, these two types are generally referred to as "microlens".

The microlens can be used for various uses, for example:

(1) To intensify luminance by focusing light in areas around picture elements in non-luminant display devices such as liquid crystal devices, as disclosed in Japanese Laid-Open Patent Publications Nos. 60-165621 to 165624, and No. 60-262131.

(2) As light pick-up means such as laser disc, compact discs, and optical magnetic disc.

(3) As a focusing means for coupling a luminant device or a receptive device to an optical fiber.

(4) As a focusing means or an image forming means for focusing an incident light in a photoelectric converting zone so as to increase the sensitivity of a primary image sensor used in a solid-state image devices such as a CCD or facsimile machines (Japanese Laid-Open Publications Nos. 54-17620 and 57-9180).

(5) As an image forming means for forming an image on a sensitive medium to be printed by a liquid crystal printer or an LED printer (Japanese Laid-Open Publication No. 63-44624, etc.).

(6) As a filter for treating photo-information.

To make microlenses, the following processes are known:

(1) A substrate containing ions is submerged in a solution of alkaline salt, and ions are exchanged between the substrate and the salt solution through a mask formed on the substrate, thereby obtaining a substrate having a distribution of indexes of refraction corresponding to the pattern of the mask ("Ion Exchange Method" Applied Optics, 21(6), page 1052 (1984), Electron Lett., 17, page 452 (1981)).

(2) A photosensitive monomer is irradiated with ultra violet rays so as to polymerize an irradiated portion of the photosensitive monomer. Thus, the irradiated portion is caused to bulge into a lens configuration under an osmotic pressure occurring between the irradiated portion and the non-irradiated portion.

(3) A photosensitive resin is patterned into circles, and heated to temperatures above its softening point so as to enable the peripheral portion of each circular pattern to sag by surface tension, this process being referred to as the "heat sagging process", (Heat Sagging Process" by Zoran D. Popovic et al - Applied Optics, 27 page 1281 (1988)).

(4) A lens substrate is mechanically shaped into a lens (Mechanical Process).

A disadvantage common to these processes is that they require several steps, and therefore take a relatively long time. As a result, they are not suitable for mass-production.

To achieve mass-production, an injection method employing a stamper made of metal such as nickel is proposed for moulding plastic material into microlenses. However, the optical device having microlenses attached by this process has a disadvantage in that the microlenses are likely to separate from the optical device because of a difference in the coefficient of expansion, when the optical device is subjected to a rise in the ambient temperature.

There is another proposal for employing a stamper whereby a microlens is directly formed on an optical device. This process requires relatively high temperature and pressure. However, such treatment is likely to damage the optical device that is normally liable to heat and pressure.

There is a further proposal for employing a metallic stamper that is applied to a photosensitive layer formed on the optical device so as to shape a lens configuration, and then the formed lens is allowed to harden under the irradiation of ultra violet rays. Under this process the ultra violet rays cannot be radiated from the side of the stamper but must be done from the side of the optical device. To effect the radiation of ultra violet rays through the optical device, the optical device should have a sufficient porosity to allow them to pass. These considerations restrict the selection of a material of which optical device are made.

The document JP-A-61 058838 discloses a process for manufacturing a lens array by melting an optical material, dropping it through an array of holes onto a base plate, and solidifying the drops.

According to one aspect of the present invention, there is provided an optical device having a main substrate and a microlens formed thereon, the microlens having a lens portion integrally formed on a lens substrate, characterised in that the microlens is bonded to the main substrate by an adhesive layer having a different index of refraction from that of the lens portion, and in that the main substrate has substantially the same coefficient of expansion as that of the lens substrate.

In a preferred embodiment, the lens portion is made of photosensitive resin.

According to another aspect of the invention, there is provided a method as claimed in claim 7.

Thus, the invention described herein makes possible the objectives of (1) providing an optical device adapted for mass-production; and (2) providing an optical device in which a microlens is secured irrespective of any changes in temperatures and any shock.

## BRIEF DESCRIPTION OF THE DRAWINGS

This invention may be better understood and its numerous objects and advantages will become apparent to those skilled in the art by references to the accompanying drawings as follows:

Figures 1A to 1E are vertical cross-sectional views illustrating a series of steps for producing a first embodiment according to the invention; and

Figures 2A to 2E are vertical cross-sectional views illustrating a series of steps for producing a second embodiment according to the invention.

## DESCRIPTION OF THE PREFERRED EMBODIMENTS

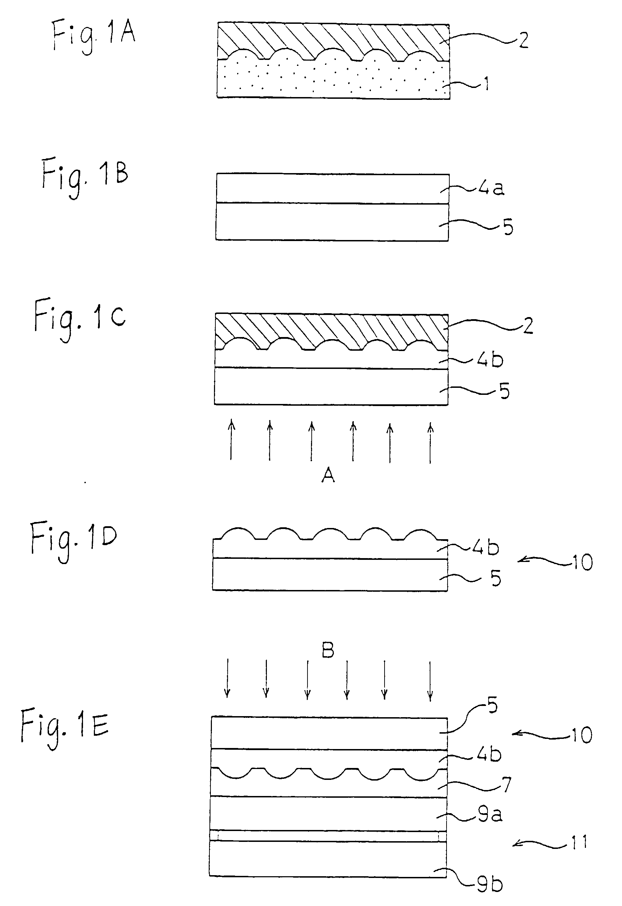

Figure 1E shows the laminated structure of layers in a transmissive liquid crystal display apparatus 11, hereinafter referred to as "display apparatus", including a microlens 10. The microlens 10 includes a lens substrate 5 and a lens portion 4b formed of a first photosensitive resin on the lens substrate 5, and is bonded to a substrate 9a of the display apparatus 11 with a second photosensitive resin layer 7, that is, a bond layer. The substrates 9a and 9b are made of silica minerals such as silica glass. In the illustrated example, the substrate 5, which has virtually the same coefficient of expansion as that of the layers **9a** and **9b**, are made of the same kind of silica minerals such as silica glass.

A process for making a microlens according to the present invention will be described with reference to Figures 1A to 1E:

At the stage of Figure 1A, a master **1** for the microlenses **10** was produced by a known heat sagging process, the microlens being a two-dimensional array which had a diameter of 38 μm, a radius of curvature of 72 μm, a central thickness of 3 μm, and an inter-lens distance of 42 μm. The microlens was designed so as to focus light to each picture element (not shown) arranged in a matrix. Then, the master **1** was coated with metal such as Ni and Cu by electrotyping so as to produce a stamper **2**.

At the stage of Figure 1B, the first photosensitive layer **4a** was formed about 100 μm thick on one of the sides of the substrate **5** of boro-silicate glass. This first photosensitive layer **4a** was later shaped into a lens portion **4b** as referred to below. The index of refraction of boro-silicate glass is 1.53, and therefore, as the first photosensitive resin, "NOA-61″ manufactured by NORLAND Inc. (index of refraction is 1.56) was used because of the approximation in the index of refraction. Likewise, "AVR-100" and "TB-3003" manufactured by THREEBOND Inc., "UV-1003" manufactured by SONYCHEMICAL Inc., and "NOA-63" and "NOA-65" manufactured by NORLAND Inc. can be used as photosensitive resin.

At the stage of Figure 1C, the stamper **2** was pressed against the photosensitive resin layer **4a** under irradiation of ultra violet rays (wavelength: about 300 to 400 nm) so as to shape it into the lens portion **4b** on the lens substrate **5**. The ultra violet rays were radiated in the direction of arrows (A) toward the lens substrate **5**.

At the stage of Figure 1D the stamper **2** was released from the lens portion **4b**. In this way a microlens **10** was obtained.

At the stage of Figure 1E, the bond layer **7** (about 30 μm) was formed with a second photosensitive resin layer on the main substrate **9a** of the display apparatus **11**, and the microlens **10** was bonded to the substrate **9a** by means of the layer **7**.

As shown in Figure 1E, the second photosensitive resin layer was irradiated with ultra violet rays (wavelength: about 300 to 400 nm) so as to harden the resin into the bond layer **7**. The ultra violet rays were radiated in the direction of arrows (B) in Figure 1E.

For the second photosensitive resin layer, "AVR-100" manufactured by THREEBOND Inc. which had a smaller index of refraction (i.e. 1.46) than that of the first photosensitive resin was used to form the bond layer **7**, and the microlens **10** was bonded to the display apparatus **11** in such a manner that the lens portion **4b** is faced thereto. Owing to the fact that the bond layer **7** was formed by the second photosensitive resin layer **7** having a smaller index of refraction than that of the first photosensitive resin, the lens portion **4b** can function as a convex lens. If the two photosensitive resins had the same index of refraction, the microlens **10** would not function as a lens.

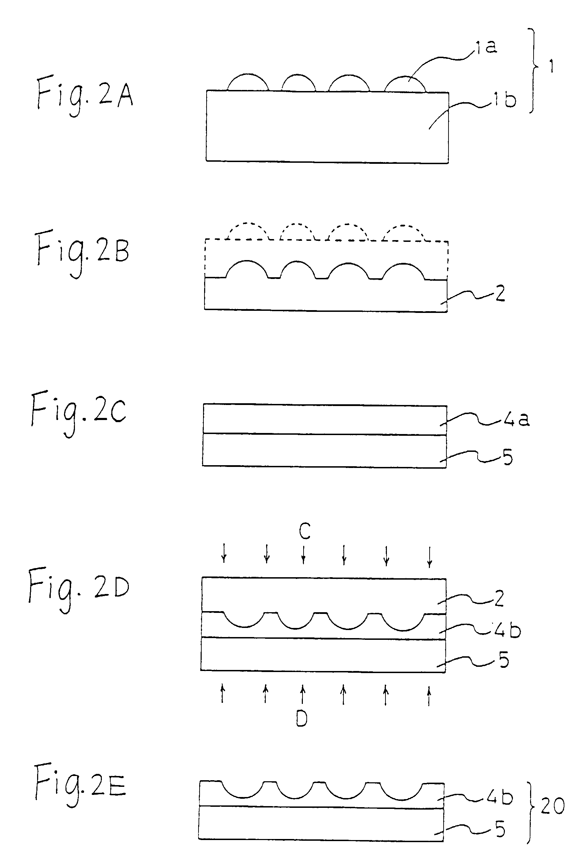

Referring to Figures 2A to 2E, a second example of the embodiment will be described:

As shown in Figure 2E, a microlens **20** used herein is formed by forming a concave lens portion **4b** on the substrate **5** made of boro-silicate glass of which the substrates **9a** and **9b** are also made.

A process of making the microlens **20** will be described:

At the stage of Figure 2A, a microlens portion **1a** is formed on a quartz glass substrate **1b** so as to form a master **1** for the microlens **20**. For a material for the microlens photoresist manufactured by a known heat sagging process can be used.

At the stage of Figure 2B the top portions of the microlens portion **1a** and the quartz glass substrate **1b** were eroded by a dry etching with a gaseous mixture of carbon tetrafluoride and oxygen.

The etching conditions such as the flow rate, the pressure and the mixing ratio (partial pressure ratio) of the gaseous mixture, the RF power and the temperatures of the substrate were adjusted to respective optimum values, thereby ensuring that the lens portion **1a** and substrate **1b** are uniformly etched. In this example, the microlens portion **1a** and the quartz glass **1b** were etched from the respective tops by a greater thickness than the microlens portion **1a** under such conditions that the ratio to be selected become equal to each other. Then, the configuration of the microlens **1a** was transferred to the quartz substrate **1b**. In this way a convex stamper **2** was obtained.

The sampler **2** can be used as a convex microlens or may be used as a master for making a concave microlens.

At the stage of Figure 2c, a first photosensitive resin layer **4a** on a substrate **5** of boro-silicate glass which is the same material for the substrate **9a** and **9b** used in the display apparatus **11**. Then, the sequence advances to the next step of Figure 2D, where the convex stamper **2** was applied to the first photosensitive resin layer **4a** irradiated with ultra violet rays was shaped and cured, thereby forming a convex lens portion **4b** on a glass substrate **5**. Ultra violet ray can be radiated in either direction of arrow (C) or (D). At the stage of Figure 2E the stamper **2** was removed from the lens portion **4b**, thus obtaining a concave microlens **20**.

The microlens **20** is attached to the display apparatus **11** by forming a bond layer **7** (second photo-sensitive layer) on the substrate **9a** and radiating ultra violet rays upon the bond layer **7** so as to secure light-curing. The microlens **20** functions as a convex lens but if it is intended to enable the microlens **20** to function as a convex lens, the second photosensitive resin should have a larger index of refraction than that of the first photosensitive resin. In the illustrated embodiment, "AVR-100" (index of refraction: 1.46) manufactured by THREEBOND Inc. was used for the first photosensitive resin, and "NOA-61" (index of refraction: 1.56) manufactured by NORLAND Inc. was used for the second photosensitive resin.

In the illustrated embodiments the microlens **10** and **20** were attached to the display apparatus **11** in such a manner that the lens portions **4b** were in contact with the bond layer **7**, thereby shortening the intervals between the picture elements in the display apparatus **11** and the lens portion **4b** of the microlens **10** and **20**. The shortened interval between the picture elements and the lens portion **4b** allows the focal distance to be short, thereby ensuring that light is focused within the picture elements.

In the first example described above, the bond layer **7** was about 30 μm thick, and the substrate **9a** was 1.1 mm thick. In order to focus light within the picture elements in the display apparatus **11**, the microlens **10** is designed to ensure that the focal length f should be 1.1 mm in the glass substrate. In this case, the thickness of the bond layer **7** is much smaller than that of the substrate **9a**, and therefore, the focal length f is expressed by the following equation (1):

$$f = r \cdot n\,3 / (n\,1 - n\,2) \qquad (1)$$

where

r :	the radius of curvature of the microlens **10**
n 1:	the index of refraction of the lens portion **4b** (lst photosensitive resign)
n 2:	the index of refraction of the bond layer **7** (2nd photosensitive resin layer)
n 3:	the index of refraction of the substrate **9a**

The value of the following theorem (2) is obtained by multiplying the equation (1) by a coefficient (n 3/n 2) which is used to convert the focal length fl into a focal length in the medium **3** (index of refraction: n 3):

$$f\,1 = r \cdot n\,2 / (n\,1 - n\,2) \qquad (2)$$

The theorem (2) is to obtain the focal length f1 in the interface between medium 1 (index of refraction: n 1) and medium 2 (index of refraction: n 2).

The following values are placed in the equation (1):

n1 =	1.56
n2 =	1.46
n3 =	1.53
r =	72 μm (radius of curvature of the microlens **10**

Thus, the focal length = 1.1 mm

It will be appreciated from this calculation that the light is focused on the picture elements in the display apparatus **11** through the microlens **10**, the bond layer **7** and the substrate **9a**.

In the illustrated embodiments, the substrates **5** of the microlenses **10** and **20** are made of boro-silicate glass as the substrate **9a** of the display apparatus **11** is. The microlens **10** and **20** are respectively bonded to the substrate **9a** of the display apparatus **11** through the bond layer **7** having a different index of refraction from that of the lens portion **4b**. The lens portion **4b** is formed on the substrate **5** by pressing a photosensitive resin layer **4a** overlaying the substrate **5** by the stamper **2** under the irradiation of ultra violet rays. The following advantages result:

(1) The lens portion **4b** of the microlenses **10** and **20** are formed on the substrate **5** made of the same material as that of the substrate **9a** of the display apparatus **11**, which means that they have the same coefficient of expansion, thereby preventing any detrimental separation from occurring between the microlens **10**, **20** and the substrate **9a** in response to changes in the ambient temperature. Since the lens portion **4b** is made of the same material as that of the bond layer **7**, they are sufficiently affiliated, thereby securing the bond between the microlenses **10**, **20** and the substrate **9a**.

(2) Since the bond layer **7** has a different index of refraction from that of the lens portion **4b**, whereby the microlenses **10** and **20** are respectively bonded to the substrate **9a** of the display apparatus **11**, the microlenses **10** and **20** can function without being affected by the fact that the lens portion **4b** is bonded to the substrate **9a** of the display apparatus **11**. This effect allows the lens portion **4b** to be disposed in opposition to the substrate **9a**, thereby shortening the focal length of the microlenses **10** and **20**. Thus, the focusing strength of the lenses **10** and **20** is enhanced.

(3) The light is focused on the picture elements in the display apparatus **11**, thereby increasing the effective porosity of the display apparatus **11**. This enhances the luminance of the display apparatus **11**, thereby securing clear image pictures on the screen.

(4) The use of the stamper **2** shortens the time required for shaping the microlens **10** and **20**, thereby increasing the mass-productivity and decreasing the production cost.

(5) The lens portion **4a** is formed by shaping a softened photosensitive layer **4a** by use of the stamper **2**, and after hardening, the shaped lens portion **4b** is readily released from the stamper **2** preferably with the use of a lubricant.

The application of the optical device equipped with a microlens according to the present invention is not limited to the display apparatus **11**, but can be made to any other optical apparatus, provided that the substrates of the microlenses 10 and 20 are respectively made of a material having the same coefficient of expansion as that of the object to which the microlenses 10 and 20 are bonded.

The microlens can be applied to any other optical apparatus in addition to the liquid crystal display panel.

It is understood that various other modifications will be apparent to and can be readily made by those skilled in the art without departing from the scope of this invention. Accordingly, it is not intended that the scope of the claims appended hereto be limited to the description as set forth herein.

## Claims

1. An optical device having a main substrate (9a) and a microlens (10;20) formed thereon, the microlens (10;20) having a lens portion (4b) integrally formed on a lens substrate (5), characterised in that the microlens (10;20) is bonded to the main substrate (9a) by an adhesive layer (7) having a different index of refraction from that of the lens portion, and in that the main substrate (9a) has substantially the same coefficient of expansion as that of the lens substrate (5).

2. An optical device according to claim 1, wherein the lens portion (4b) is made of photosensitive resin.

3. An optical device as claimed in claim 1 or claim 2, wherein the lens portion (4b) comprises an array of individual microlenses for converging incident light to a plurality of regions of the main substrate (9a), the lens portion (4b) being attached to the lens substrate (5) at a side of the lens portion (4b) remote from the main substrate (9a).

4. An optical device as claimed in claim 3, wherein the lens portion (4b) comprises an array of convex lenses and the refractive index of the adhesive layer (7) is smaller than the refractive index of the lens portion (4b).

5. An optical device as claimed in claim 3, wherein the lens portion (4b) comprises an array of concave lenses and the refractive index of the adhesive layer (7) is greater than the refractive index of the lens portion (4b).

6. An optical device claimed in any preceding claim, wherein the lens portion (4b) has substantially the same coefficient of expansion as that of the adhesive layer (7).

7. A method of forming an optical device having a lens substrate (5) and a microlens portion (4b), comprising the steps of:

   stamping a photosensitive layer (4a) to provide a surface defining the microlens portion (4b); and
   curing the photosensitive layer; characterised by

adhering said surface of the microlens portion (4b) to a substrate (9a) of the optical device (11) using an adhesive layer (7) having a refractive index different from that of the photosensitive layer.

8. A method as claimed in claim 7, wherein the photosensitive layer (4a) is disposed on the lens substrate (5) which has a coefficient of expansion substantially the same as that of the substrate (9a) of the optical device (11).

9. A method as claimed in claim 7 or 8, wherein the photosensitive layer (4a) is stamped with a metal stamper (2).

10. A method as claimed in any one of claims 7 to 9, further comprising curing the adhesive layer (7) under ultraviolet radiation through the microlens array.

11. A method as claimed in claim 7 or 8, wherein the photosensitive layer (4a) is stamped with a light-permissive stamper (2).

12. A method as claimed in claim 11, wherein the photosensitive layer (4a) is cured under ultraviolet radiation through the light-permissive stamper (2).

13. A method as claimed in claim 11 or 12, including the steps of forming a microlens (1a) on a glass substrate (1b) and dry etching the microlens (1a) and glass substrate (1b) to form the stamper (2), which is convex and made of glass.

**Patentansprüche**

1. Optisches Bauelement mit einem Hauptsubstrat (9a) und einer darauf ausgebildeten Mikrolinse (10; 20), die über einen Linsenabschnitt (4b) verfügt, der einstückig auf einem Linsensubstrat (5) ausgebildet ist, **dadurch gekennzeichnet, daß** die Mikrolinse (10; 20) mittels einer Klebeschicht (7) mit dem Hauptsubstrat (9a) verbunden ist, die einen anderen Brechungsindex als der Linsenabschnitt aufweist, und daß das Hauptsubstrat (9a) im wesentlichen denselben Expansionskoeffizient wie das Linsensubstrat (5) aufweist.

2. Optisches Bauelement nach Anspruch 1, bei dem der Linsenabschnitt (4b) aus einem photoempfindlichen Harz besteht.

3. Optisches Bauelement nach Anspruch 1 oder Anspruch 2, bei dem der Linsenabschnitt (4b) ein Array aus einzelnen Mikrolinsen zum Konvergieren von einfallendem Licht auf eine Anzahl von Bereichen des Hauptsubstrats (9a) aufweist, wobei der Linsenabschnitt (4b) auf dem Linsensubstrat (5) so angebracht ist, daß der Linsenabschnitt (4b) entfernt vom Hauptsubstrat (9a) liegt.

4. Optisches Bauelement nach Anspruch 3, bei dem der Linsenabschnitt (4b) ein Array konvexer Linsen aufweist und der Brechungsindex der Kleberschicht (7) kleiner als der Brechungsindex des Linsenabschnitts (4b) ist.

5. Optisches Bauelement nach Anspruch 3, bei dem der Linsenabschnitt (4b) ein Array konkaver Linsen aufweist und der Brechungsindex der Kleberschicht (7) größer als der Brechungsindex des Linsenabschnitts (4b) ist.

6. Optisches Bauelement nach einem der vorstehenden Ansprüche, bei dem der Linsenabschnitt (4b) im wesentlichen den gleichen Expansionskoeffizient wie die Klebeschicht (7) aufeist.

7. Verfahren zum Herstellen eines optischen Bauelements mit einem Linsensubstrat (5) und einem Mikrolinsenabschnitt (4b), mit den folgenden Schritten:

- Bearbeiten einer photoempfindlichen Schicht (4a) mit einem Stempel, um eine Oberfläche zu schaffen, die einen Mikrolinsenabschnitt (4b) definiert; und
- Aushärten der photoempfindlichen Schicht;

**gekennzeichnet durch**

- Ankleben der Oberfläche des Mikrolinsenabschnitts (4b) an ein Substrat (9a) des optischen Bauelements (11) unter Verwendung einer Kleberschicht (7) mit einem Brechungsindex, der sich von dem photoempfindlichen Schicht unterscheidet.

8. Verfahren nach Anspruch 7, bei dem die photoempfindliche Schicht (4a) auf einem Linsensubstrat (5) angebracht wird, dessen Expansionskoeffizient im wesentlichen mit dem des Substrats (9a) des optischen Bauelements (11) übereinstimmt.

9. Verfahren nach einem der Ansprüche 7 oder 8, bei dem die photoempfindliche Schicht (4a) mittels eines Metallstempels (2) bearbeitet wird.

10. Verfahren nach einem der Ansprüche 7 bis 9, das ferner das Aushärten der Kleberschicht (7) mit Ultraviolettstrahlung durch das Mikrolinsenarray hindurch umfaßt.

11. Verfahren nach einem der Ansprüche 7 oder 8, bei dem die photoempfindliche Schicht (4a) mit einem lichtdurchlässigen Stempel (2) bearbeitet wird.

**12.** Verfahren nach Anspruch 11, bei dem die photoempfindliche Schicht (4a) bei Ultravioletteinstrahlung durch den lichtdurchlässigen Stempel (2) hindurch ausgehärtet wird.

**13.** Verfahren nach einem der Ansprüche 11 oder 12, mit den Schritten des Ausbildens einer Mikrolinse (1a) auf einem Glassubstrat (1b) und des Trockenätzens der Mikrolinse (1a) und des Glassubstrats (1b), um den Stempel (2) herzustellen, der konvex ist und aus Glas besteht.

## Revendications

**1.** Dispositif optique comprenant un substrat principal (9a) et une microlentille (10 ; 20) formée sur celui-ci, la microlentille (10 ; 20) ayant une partie de lentille (4b) faisant partie intégrante d'un substrat de lentille (5), caractérisé en ce que la microlentille (10 ; 20) est liée au substrat principal (9a) par une couche adhésive (7) ayant un indice de réfraction différent de celui de la partie de lentille, et en ce que le substrat principal (9a) a sensiblement le même coefficient de dilatation que celui du substrat de lentille (5).

**2.** Dispositif optique selon la revendication 1, dans lequel la partie de lentille (4b) est réalisée en résine photosensible.

**3.** Dispositif optique selon la revendication 1 ou 2, dans lequel la partie de lentille (4b) comprend un réseau de microlentilles individuelles destiné à faire converger de la lumière incidente sur une pluralité de régions du substrat principal (9a), la partie de lentille (4b) étant fixée au substrat de lentille (5) sur une face de la partie de lentille (4b) éloignée du substrat principal (9a).

**4.** Dispositif optique selon la revendication 3, dans lequel la partie de lentille (4b) comprend un réseau de lentilles convexes et dans lequel l'indice de réfraction de la couche adhésive (7) est inférieure à l'indice de réfraction de la partie de lentille (4b).

**5.** Dispositif optique selon la revendication 3, dans lequel la partie de lentille (4b) comprend un réseau de lentilles concaves et dans lequel l'indice de réfraction de la couche adhésive (7) est supérieure à l'indice de réfraction de la partie de lentille (4b).

**6.** Dispositif optique selon l'une des revendications précédente, dans lequel la partie de lentille (4b) a sensiblement le même coefficient de dilatation que la couche adhésive (7).

**7.** Procédé pour réaliser un dispositif optique ayant un substrat de lentille (5) et une partie de microlentille (4b), comprenant les étapes consistant à :

emboutir une couche photosensible (4a) pour former une surface définissant la partie de microlentille (4b) ; et
durcir la couche photosensible ; caractérisé par le fait de faire adhérer ladite surface de la partie de microlentille (4b) à un substrat (9a) du dispositif optique (11) au moyen d'une couche adhésive (7) ayant un indice de réfraction différent de celui de la couche photosensible.

**8.** Procédé selon la revendication 7, dans lequel la couche photosensible (4a) est disposée sur le substrat de lentille (5) lequel a un coefficient de dilatation sensiblement identique à celui du substrat (9a) du dispositif optique (11).

**9.** Procédé selon la revendication 7 ou 8, dans lequel la couche photosensible (4a) est emboutie au moyen d'un poinçon métallique (2).

**10.** Procédé selon l'une quelconque des revendications 7 à 9, comprenant en outre l'opération consistant à durcir la couche adhésive (7) sous un rayonnement ultraviolet ayant traversé le réseau de microlentilles.

**11.** Procédé selon la revendication 7 ou 8, dans lequel la couche photosensible (4a) est emboutie au moyen d'un poinçon (2) franchissable par la lumière.

**12.** Procédé selon la revendication 11, dans lequel la couche photosensible (4a) est durcie sous rayonnement ultraviolet à travers le poinçon (2) franchissable par la lumière.

**13.** Procédé selon la revendication 11 ou 12, comprenant les étapes consistant à former une microlentille (1a) sur un substrat en verre (1b) et à décaper à sec la microlentille (1a) ainsi que le substrat en verre (1b) pour former le poinçon (2), qui est convexe et fabriqué en verre.

Fig. 1A

Fig. 1B

Fig. 1C

A

Fig. 1D

B

Fig. 1E

Fig. 2A

1a
1
1b

Fig. 2B

2

Fig. 2C

4a
5

Fig. 2D

C

2
4b
5

D

Fig. 2E

4b
20
5